(19) **Europäisches Patentamt / European Patent Office / Office européen des brevets**

(11) **EP 1 870 717 B1**

(12) **EUROPEAN PATENT SPECIFICATION**

(45) Date of publication and mention
of the grant of the patent:
**08.01.2014 Bulletin 2014/02**

(51) Int Cl.:
***G01R 27/16*** (2006.01)    ***H02H 7/26*** (2006.01)

(21) Application number: **06115706.1**

(22) Date of filing: **20.06.2006**

(54) **System and method for determining phase-to-earth admittances of a three-phase electric line**

System und Verfahren zur Bestimmung von Phase-Erde-Admittanzen einer Dreiphasenleitung

Système et procédé de détermination des admittances entre phase et terre d'une ligne électrique triphasée.

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**26.12.2007 Bulletin 2007/52**

(73) Proprietor: **ABB Technology AG
8050 Zürich (CH)**

(72) Inventors:
• **Altonen, Janne
FI-33720 Tampere (FI)**
• **Wahlroos, Ari
FI-65320 Vaasa (FI)**

(74) Representative: **Kolster Oy Ab
Iso Roobertinkatu 23
PO Box 148
00121 Helsinki (FI)**

(56) References cited:
**EP-A- 1 089 081    WO-A-01/22104**

• **NIKANDER A ET AL: "Methods for earth fault identification and distance estimation in a compensated medium voltage distribution network" ENERGY MANAGEMENT AND POWER DELIVERY, 1998. PROCEEDINGS OF EMPD '98. 1998 INTERNATIONAL CONFERENCE ON SINGAPORE 3-5 MARCH 1998, NEW YORK, NY, USA,IEEE, US, vol. 2, 3 March 1998 (1998-03-03), pages 595-600, XP010293689 ISBN: 0-7803-4495-2**

**Description**

FIELD OF THE INVENTION

The present invention relates to determining estimate values for phase-to-earth admittances of a three-phase electric line of an electric power system.

BACKGROUND OF THE INVENTION

In an isolated neutral system, the neutral has no intentional connection to earth. However, the system is connected to earth via phase-to-earth capacitances and phase-to-earth leakage resistances. The impedance to earth is mainly capacitive as phase-to-earth leakage resistances are in the order of 10 to 20 times larger than the phase-to-earth capacitive reactances. The phase-to-earth capacitive reactances have typically very high magnitudes, in the order of several thousands of ohms ($X_c = 1/(\omega \cdot C_0)$).

In a perfectly balanced and symmetrical power system all the phase impedances and phase-to-earth admittances are equal. This means that the vectorial sum of system capacitive charging currents and phase voltages is zero. Efforts are typically made to obtain a balanced system, e.g. by transposing transmission line conductors.

In reality the power systems are, however, never perfectly balanced. This means that both the phase-to-earth capacitance and leakage resistance values are different for different phases. This is true especially for overhead-lines. If the phase-to-earth capacitances are not equal, the system produces steady-state zero-sequence quantities. The magnitude of steady-state residual current value can be measured with a core-balance current transformer or current transformers connected in Holmgreen connection (sum connection). The steady-state residual voltage can be measured with voltage transformers connected in open-delta or with a voltage transformer connected between system neutral point and earth. Typically these quantities are small, but in large systems the cumulative effect of unequal capacitances can generate appreciable zero-sequence quantities.

System phase-to-earth capacitance unbalance produces steady-state zero-sequence quantities, which are harmful in many ways in protection relay applications. First of all, they limit the sensitivity of earth-fault protection. Secondly, they are an additional error source for protection algorithms in relays. In state-of-art relay algorithms, the system unbalance is being considered and taken account for. One typical method subtracts the steady-state unbalance quantities from the faulted ones. The obtained quantities are called as 'delta-quantities'. At least for some algorithms this seems not to be the sufficient remedy and therefore phase specific phase-to-earth admittances should be determined directly. They could then be more easily taken into account in protective relaying algorithms.

Typically, the accurate values of phase-to-earth admittances are unknown for network operators. This is due to fact that their values depend on actual installation conditions and they may therefore vary. The manufacturer data sheets give only "typical values", which are not phase specific. According to practical experiences from field tests the values of phase-to-earth capacitances may deviate as much as 10 - 20 % from the data sheet values.

Documents: "Novel Methods for Earth Fault Management in Isolated or Compensated Medium Voltage Electricity Distribution Networks", Ari Nikander, Tampere University of Technology, Publications 363, Tampere 2002, and "New directional ground-fault element improve sensitivity in ungrounded and compensated networks", Jeff Roberts, et al., Schweitzer Engineering Laboratories, Pullman, WA, USA, 2001, WO 01/22104 and "Methods for earth fault identification and distance estimation in a compensated medium voltage distribution network", Ari Nikander et al., IEEE Cat. No: 98EX137, pages 595-600 describe methods for determination of feeder admittance values. The values are, however, not phase specific, but mean values for all phases.

BRIEF DESCRIPTION OF THE INVENTION

An object of the invention is thus to provide a method and an apparatus for implementing the method for calculation of estimate values for phase-to-earth admittances. The objects of the invention are achieved by a method, a system and a computer program product which are characterized by what is stated in independent claims 1, 6 and 12. The preferred embodiments of the invention are disclosed in the dependent claims.

The invention is based on the idea of determining estimate values for phase-to-earth admittances of an electric line of an electric power system by utilizing healthy state measurements and faulty state measurements during a phase-to-earth fault in the electric power system outside the electric line.

An advantage of the invention is that the estimates for the phase-to-earth admittances of the electric line can be determined after one single-phase-to-earth fault occurring in the electric power system outside the electric line. In addition, the phase-to-earth fault may be either a natural fault or intentionally caused for the purpose of determining the admittance values. The determined phase-specific phase-to-earth admittance values can be applied in various protective relay algorithms, e.g. in high accuracy fault location algorithms and in power quality functions, and it can be valuable information for system operators.

BRIEF DESCRIPTION OF THE DRAWINGS

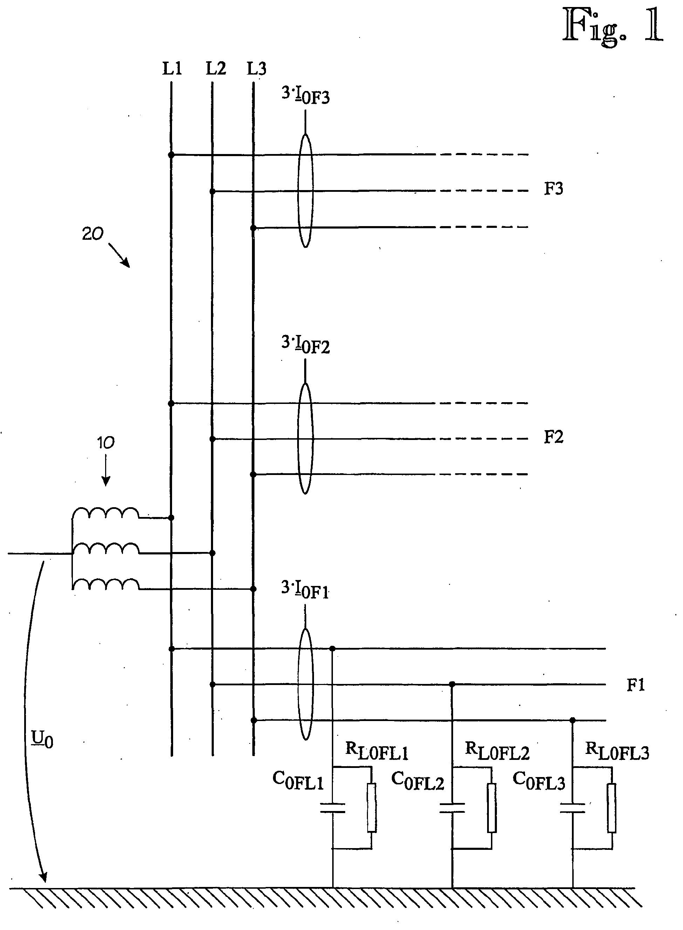

In the following the invention will be described in greater detail by means of preferred embodiments with reference to the attached drawings, in which Figure 1 is a diagram illustrating an electric network in which the invention can be used.

DETAILED DESCRIPTION OF THE INVENTION

The use of the method and system of the invention is not limited to any specific system, but they can be used in connection with various three-phase electric systems to determine the phase specific admittance values for a certain three-phase electric line of an electric power system. The electric line can be a feeder, for example, and may be an overhead-line or a cable or a combination of both. The electric power system can be an electric transmission or distribution network or a component thereof, for example, and may comprise several feeders. Moreover, the use of the invention is not limited to systems employing 50-Hz or 60-Hz fundamental frequencies or to any specific voltage level.

Figure 1 is a diagram illustrating an electric power system, in this example an electric network, in which the invention can be applied. The figure shows only components necessary for understanding the invention. The exemplary electric network can be a medium voltage (e.g. 20 kV) distribution network fed through a substation comprising a transformer 10 and a busbar 20. The phases of the three-phase system are identified as L1, L2 and L3. The figure further shows three electric line outlets, i.e. feeders F1, F2 and F3. Feeder F1 has been illustrated in more detail and the phase-specific phase-to-earth capacitances $C_{0FL1}$, $C_{0FL2}$ and $C_{0FL3}$ as well as leakage resistances $R_{L0FL1}$, $R_{L0FL2}$ and $R_{L0FL3}$ of feeder F1 are shown. Corresponding phase-specific phase-to-earth admittances $\underline{Y}_{0L1}$, $\underline{Y}_{0L2}$ and $\underline{Y}_{0L3}$ of feeder F1 are as follows:

$$\underline{Y}_{0L1} = \frac{1}{R_{L0FL1}} + j \cdot \omega \cdot C_{0FL1} \qquad \text{(eq1)}$$

$$\underline{Y}_{0L2} = \frac{1}{R_{L0FL2}} + j \cdot \omega \cdot C_{0FL2} \qquad \text{(eq2)}$$

$$\underline{Y}_{0L3} = \frac{1}{R_{L0FL3}} + j \cdot \omega \cdot C_{0FL3} \qquad \text{(eq3)}$$

$\underline{U}_0$ is the zero sequence (residual) voltage, which is common to the whole network. $3 \cdot \underline{I}_{0F1}$, $3 \cdot \underline{I}_{0F2}$, and $3 \cdot \underline{I}_{0F3}$ are the residual currents (sum of phase currents) of feeders F1, F2 and F3 (wherein $\underline{I}_{0F1}$, $\underline{I}_{0F2}$ and $\underline{I}_{0F3}$ are zero sequence component currents) and can be measured at the beginning of the feeders as shown in the figure. It should be noted that there might be any number of feeders or other network elements in the network. There may also be several feeding substations. Further, the invention can be utilized with a switching station without a transformer 10, for example.

The following first explains the theory behind the invention for estimation of the phase specific admittance values for a certain feeder.

Total admittances of a feeder ($\underline{Y}_{0fd}$), background network ($\underline{Y}_{0bg}$) and the whole network ($\underline{Y}_0$):

The total admittances (sum of phase admittances $\underline{Y}_{0L1}$, $\underline{Y}_{0L2}$ and $\underline{Y}_{0L3}$) of a feeder ($\underline{Y}_{0fd}$) can be determined during a single-phase earth fault in any of the phases outside the feeder in question:

$$\underline{Y}_{0fd} = \frac{3 \cdot \Delta \underline{I}_{0F}}{\Delta \underline{U}_{0F}} = \underline{Y}_{afd} + \underline{Y}_{ufd} \qquad \text{(eq4)}$$

where

$\Delta \underline{I}_{0F}$ = change in the measured zero-sequence current due to the fault,

$\Delta \underline{U}_{0F}$ = change in the measured zero-sequence voltage due to the fault,

$\underline{Y}_{afd}$ = symmetrical part of the total admittance $\underline{Y}_{0fd}$ and

$\underline{Y}_{ufd}$ = unsymmetrical part of the total admittance $\underline{Y}_{0fd}$ .

The total admittances of the background network $(\underline{Y}_{0bg})$, i.e. the network excluding the feeder in question, can be determined during a single-phase earth fault in any of the phases inside the feeder in question:

$$\underline{Y}_{0bg} = -\frac{3 \cdot \Delta \underline{I}_{0F}}{\Delta \underline{U}_{0F}} = \underline{Y}_{abg} + \underline{Y}_{ubg} \qquad \text{(eq5)}$$

where

$\Delta \underline{I}_{0F}$ = change in the measured zero-sequence current due to the fault,

$\Delta \underline{U}_{0F}$ = change in the measured zero-sequence voltage due to the fault,

$\underline{Y}_{abg}$ = symmetrical part of the total admittance $\underline{Y}_{0bg}$ and

$\underline{Y}_{ubg}$ = unsymmetrical part of the total admittance $\underline{Y}_{0bg}$.

The total admittance of the whole network is the sum of feeder and background network admittances:

$$\underline{Y}_0 = \underline{Y}_{0fd} + \underline{Y}_{0bg} \qquad \text{(eq6)}$$

As the equations eq4, eq5 and eq6 do not depend on the fault resistance, an occurrence of natural earth fault can thus be utilized for the determination. Determination of $\underline{Y}_{0fd}$ requires that a natural fault occurs outside the feeder in question whereas the determination of $\underline{Y}_{0bg}$ requires that a natural fault occurs inside the feeder in question regardless of the phase and fault resistance.

Asymmetry factors of the whole network $(\underline{k})$, the feeder $(\underline{k}_{fd})$ and the background network $(\underline{k}_{bg})$:

The asymmetry factor for the whole network $(\underline{k})$ can be determined based on healthy state measurements:

$$\underline{k} = \frac{U_{0H}}{U_N}(m + jd) \qquad \text{(eq7)}$$

where

$\underline{U}_{0H}$ = healthy state zero-sequence voltage

$U_N$ = nominal phase voltage

$d$ = losses

$m$ = mismatch (in case of an isolated network m equals to -1).

Losses can be calculated on the basis of measured $\underline{Y}_0$:

$$d = \frac{\text{Re}(\underline{Y}_0)}{\text{Im}(\underline{Y}_0)} \qquad \text{(eq7.1)}$$

where

$Re(\underline{Y}_0)$ = real part of $\underline{Y}_0$

$Im(\underline{Y}_0)$ = imaginary part of $\underline{Y}_0$

**4**

The asymmetry factor for the feeder ($\underline{k}_{fd}$) can be determined based on healthy state measurements and measured $\underline{Y}_{0fd}$:

$$\underline{k}_{fd} = \frac{3 \cdot \underline{I}_{0H} - \underline{Y}_{0fd}\underline{U}_{0H}}{j \operatorname{Im}(\underline{Y}_{0fd})U_N} \qquad \text{(eq8)}$$

where

$\underline{U}_{0H}$ = healthy state zero-sequence voltage
$\underline{I}_{0H}$ = healthy state zero-sequence current
$U_N$ = nominal phase voltage
$\underline{Y}_{0fd}$ = total phase-to-earth admittance of the feeder.

The asymmetry factor for the background network ($\underline{k}_{bg}$) can be determined using previously calculated and measured values:

$$\underline{k}_{bg} = \frac{1}{\underline{Y}_{0bg}}\left(\underline{Y}_0\underline{k} - \underline{Y}_{0fd}\underline{k}_{fd}\right) \qquad \text{(eq9)}$$

or alternatively:

$$\underline{k}_{bg} = \frac{-3 \cdot \underline{I}_{0H} - \underline{Y}_{0bg}\underline{U}_{0H}}{j \operatorname{Im}(\underline{Y}_{0bg})U_N} \qquad \text{(eq9.1)}$$

Symmetrical and unsymmetrical part of the phase-to-earth admittances:
Utilizing the previously calculated asymmetry factors, the phase-to-earth admittances can be divided into unsymmetrical and symmetrical parts:
The unsymmetrical part is for the background network:

$$\underline{Y}_{ubg} = \underline{k}_{bg}\underline{Y}_{0bg} \qquad \text{(eq10)}$$

And for the feeder:

$$\underline{Y}_{ufd} = \underline{k}_{fd}\underline{Y}_{0fd} \qquad \text{(eq11)}$$

The symmetrical part is for the background network:

$$\underline{Y}_{abg} = \underline{Y}_{0bg} - \underline{Y}_{ubg} \qquad \text{(eq12)}$$

And for the feeder:

$$\underline{Y}_{afd} = \underline{Y}_{0fd} - \underline{Y}_{ufd} \qquad\qquad \text{(eq13)}$$

After having measured and calculated the above quantities, phase specific admittance values of the feeder in question can be calculated using the equations below.

$$\underline{Y}_{0L1EF} = \frac{\underline{I}_{0F\_L1}}{\underline{U}_{0F\_L1}} = \frac{-\underline{Y}_{ubg}\underline{Y}_{afd} - \underline{Y}_f\underline{Y}_{afd} + \underline{Y}_{ufd}\underline{Y}_{abg}}{-3\cdot\left(\underline{Y}_{ubg} + \underline{Y}_{ufd} + \underline{Y}_f\right)}$$

for phase L1 earth fault (eq14)

$$\underline{Y}_{0L2EF} = \frac{\underline{I}_{0F\_L2}}{\underline{U}_{0F\_L2}} = \frac{\underline{Y}_{ubg}\underline{Y}_{afd} + \underline{a}^2\underline{Y}_f\underline{Y}_{afd} + \underline{a}^2\underline{Y}_f\underline{Y}_{ufd} - \underline{Y}_f\underline{Y}_{ufd} - \underline{Y}_{ufd}\underline{Y}_{abg}}{3\cdot\left(\underline{Y}_{ubg} + \underline{Y}_{ufd} + \underline{a}^2\underline{Y}_f\right)}$$

for phase L2 earth fault (eq15)

$$\underline{Y}_{0L3EF} = \frac{\underline{I}_{0F\_L3}}{\underline{U}_{0F\_L3}} = \frac{-\underline{Y}_{ubg}\underline{Y}_{afd} + \underline{Y}_f\underline{Y}_{ufd} - \underline{a}\underline{Y}_f\underline{Y}_{afd} - \underline{a}\underline{Y}_f\underline{Y}_{ufd} + \underline{Y}_{ufd}\underline{Y}_{abg}}{-3\cdot\left(\underline{Y}_{ubg} + \underline{Y}_{ufd} + \underline{a}\underline{Y}_f\right)}$$

for phase L3 earth fault (eq16)

where $Y_f$ corresponds to $1/R_f$ ($R_f$ is the fault resistance) and
$\underline{I}_{0F\_Lx}$ = measured zero sequence current of the feeder in case of outside fault in phase x
$\underline{U}_{0F\_Lx}$ = measured residual voltage of the network in case of outside fault in phase x.

Letting $\mathbf{Y}_f > inf$ (fault resistance = 0) and calculating:

$$\underline{Y}_{0L1} = \underline{Y}_{0L3EF} + \underline{Y}_{0L2EF} - \underline{Y}_{0L1EF} \qquad\qquad \textbf{for phase L1 (eq17)}$$

$$\underline{Y}_{0L2} = 2\cdot\underline{Y}_{0L3EF} - \underline{Y}_{0L1} \qquad\qquad \textbf{for phase L2 (eq18)}$$

$$\underline{Y}_{0L3} = 2\cdot\underline{Y}_{0L2EF} - \underline{Y}_{0L1} \qquad\qquad \textbf{for phase L3 (eq19)}$$

where $\underline{Y}_{0L1}$, $\underline{Y}_{0L2}$ and $\underline{Y}_{0L3}$ are finally the estimated phase specific admittance values of the feeder in question.
The real part and imaginary part of the estimated phase specific admittance values $\underline{Y}_{0L1}$, $\underline{Y}_{0L2}$ and $\underline{Y}_{0L3}$ can further be determined using the following equations:

$$\text{Im}(\underline{Y}_{0L1}) = \text{Im}(\frac{\underline{Y}_{afd}}{3} + \underline{Y}_{ufd}) \text{ for phase L1} \qquad\qquad \text{(eq20)}$$

$$\text{Im}(\underline{Y}_{0L2}) = \text{Im}(\frac{\underline{Y}_{afd}}{3} + \frac{j\sqrt{3}\underline{Y}_{ufd}}{3}) \text{ for phase L2} \qquad \text{(eq21)}$$

$$\text{Im}(\underline{Y}_{0L3}) = \text{Im}(\frac{\underline{Y}_{afd}}{3} - \frac{j\sqrt{3}\underline{Y}_{ufd}}{3}) \text{ for phase L3} \qquad \text{(eq22)}$$

$$\text{Re}(\underline{Y}_{0L1}) = \frac{\sqrt{3}}{3}(\text{Im}(\underline{Y}_{0L3}) - \text{Im}(\underline{Y}_{0L2})) + \text{Re}(\underline{Y}_{afd} + \underline{Y}_{ufd}) - \frac{2}{3}\text{Re}(\underline{Y}_{afd})$$

$$\text{(eq20a)}$$

$$\text{Re}(\underline{Y}_{0L2}) = \frac{\sqrt{3}}{3}(\text{Im}(\underline{Y}_{0L1}) - \text{Im}(\underline{Y}_{0L3})) + \text{Re}(\underline{Y}_{afd} + \underline{Y}_{ufd}) - \frac{2}{3}\text{Re}(\underline{Y}_{afd} + (1 - \underline{a})\underline{Y}_{ufd})$$

$$\text{(eq21a)}$$

$$\text{Re}(\underline{Y}_{0L3}) = \frac{\sqrt{3}}{3}(\text{Im}(\underline{Y}_{0L2}) - \text{Im}(\underline{Y}_{0L1})) + \text{Re}(\underline{Y}_{afd} + \underline{Y}_{ufd}) - \frac{2}{3}\text{Re}(\underline{Y}_{afd} + (1 - \underline{a}^2)\underline{Y}_{ufd})$$

$$\text{(eq22a)}$$

Thus, the phase specific phase-to-earth admittance values of the electric line can be estimated on the basis of the symmetrical part and unsymmetrical part of the determined sum of phase admittances of the electric line i.e. $Y_{afd}$ and $\underline{Y}_{ufd}$, respectively.

In the following, the determining of estimate values for the phase-to-earth admittances of the three-phase electric line F1, F2 or F3 of an electric power system according to embodiments of the invention is described in more detail. The current and voltage values used in the following are preferably obtained by a suitable measuring arrangement including e.g. current and voltage transducers connected to the phases L1, L2 and L3 of the electric power system. In most of the existing protection systems these values are readily available and thus the implementation of the invention does not necessarily require any separate measuring arrangements. How these values are obtained is of no relevance to the basic idea of the invention and depends on the particular electricity system to be monitored.

According to an embodiment of the invention, first a sum of phase-to-earth admittances of the electric line F1, F2 or F3 is determined after a phase-to-earth fault has occurred in the electric power system outside the electric line in question on the basis of a change in a monitored zero-sequence current $\underline{I}_{0F1}$, $\underline{I}_{0F2}$ or $\underline{I}_{0F3}$ of the electric line due to the phase-to-earth fault and a change in a monitored zero-sequence voltage $\underline{U}_0$ of the electric power system due to the phase-to-earth fault. According to an embodiment of the invention, the sum of phase-to-earth admittances of the electric line is determined according to the following formula:

$$\underline{Y}_{0fd} = \frac{3 \cdot \Delta\underline{I}_{0F}}{\Delta\underline{U}_{0F}}, \qquad \text{(eq23)}$$

where

$\underline{\Delta I}_{0F}$ = change in the monitored zero-sequence current of the electric line due to a phase-to-earth fault in the electric power system outside the electric line

$\underline{\Delta U}_{0F}$ = change in the monitored zero-sequence voltage of the electric power system due to a phase-to-earth fault in the electric power system outside the electric line.

Next, according to an embodiment of the invention, an unsymmetrical part and a symmetrical part of the sum of phase-to-earth admittances of the electric line are determined on the basis of a healthy state zero-sequence voltage of the electric power system, a healthy state zero-sequence current of the electric line, a nominal phase voltage of the electric power system and the sum of phase-to-earth admittances of the electric line. According to an embodiment of the invention, the unsymmetrical part of the sum of phase-to-earth admittances of the electric line is determined according to the following formula:

$$\underline{Y}_{ufd} = \frac{3 \cdot \underline{I}_{0H} - \underline{Y}_{0fd}\underline{U}_{0H}}{j\mathrm{Im}(\underline{Y}_{0fd})U_N} \cdot \underline{Y}_{0fd} \ , \qquad \text{(eq24)}$$

where

$\underline{U}_{0H}$ = healthy state zero-sequence voltage of the electric power system
$\underline{I}_{0H}$ = healthy state zero-sequence current of the electric line
$U_N$, = nominal phase voltage of the electric power system
$\underline{Y}_{0fd}$ = sum of phase-to-earth admittances of the electric line,

Then the symmetrical part of the sum of phase-to-earth admittances of the electric line can be determined according to the following formula:

$$\underline{Y}_{afd} = \underline{Y}_{0fd} - \underline{Y}_{ufd} \qquad \text{(eq25)}$$

Finally, the phase-to-earth admittances of the three-phase electric line can be determined on the basis of the symmetrical part and unsymmetrical part of the determined sum of phase admittances of the electric line. According to an embodiment of the invention, the phase-to-earth admittances of the three-phase electric line are determined according to the following formulas:

$$\mathrm{Im}(\underline{Y}_{0L1}) = \mathrm{Im}(\frac{\underline{Y}_{afd}}{3} + \underline{Y}_{ufd}) \text{ for phase L1} \qquad \text{(eq26)}$$

$$\mathrm{Im}(\underline{Y}_{0L2}) = \mathrm{Im}(\frac{\underline{Y}_{afd}}{3} + \frac{j\sqrt{3}\underline{Y}_{ufd}}{3}) \text{ for phase L2} \qquad \text{(eq27)}$$

$$\mathrm{Im}(\underline{Y}_{0L3}) = \mathrm{Im}(\frac{\underline{Y}_{afd}}{3} - \frac{j\sqrt{3}\underline{Y}_{ufd}}{3}) \text{ for phase L3} \qquad \text{(eq28)}$$

and

$$Re(\underline{Y}_{0L1}) = \frac{\sqrt{3}}{3}(Im(\underline{Y}_{0L3}) - Im(\underline{Y}_{0L2})) + Re(\underline{Y}_{afd} + \underline{Y}_{ufd}) - \frac{2}{3}Re(\underline{Y}_{afd})$$

(eq26a)

$$Re(\underline{Y}_{0L2}) = \frac{\sqrt{3}}{3}(Im(\underline{Y}_{0L1}) - Im(\underline{Y}_{0L3})) + Re(\underline{Y}_{afd} + \underline{Y}_{ufd}) - \frac{2}{3}Re(\underline{Y}_{afd} + (1-\underline{a})\underline{Y}_{ufd})$$

(eq27a)

$$Re(\underline{Y}_{0L3}) = \frac{\sqrt{3}}{3}(Im(\underline{Y}_{0L2}) - Im(\underline{Y}_{0L1})) + Re(\underline{Y}_{afd} + \underline{Y}_{ufd}) - \frac{2}{3}Re(\underline{Y}_{afd} + (1-\underline{a}^2)\underline{Y}_{ufd})$$

(eq28a)

The invention can be realized by utilizing natural earth faults occurring in the electric power system. Another possibility is to intentionally cause an earth fault for the purpose of determining the admittance values. According to an embodiment of the invention, a phase-to-earth fault is caused in the electric power system outside the electric line, whose phase-to-earth admittance values are to be determined, in order to determine the sum of phase-to-earth admittances of the electric line. The best accuracy will be obtained if an intentional earth fault is caused in the substation busbar 20 in case the electric power system is an electric network comprising a substation and one or more feeders F1, F2 and F3. By conducting one single-phase earth fault test in the substation busbar 20, the phase-to-earth admittance values of all connected feeders F1, F2 and F3 can be estimated simultaneously. The calculated value(s) corresponds to the current switching state of the feeder(s). If the switching state changes, then the test should be repeated. If a natural fault occurs in one of the feeders F1, F2 or F3 of the electric network, the phase-to-earth admittance values of all connected feeders except the one where the fault is located can be estimated simultaneously.

According to an embodiment of the invention, the admittance estimates are updated always when a natural fault occurs in the network. As a result, the estimated admittance values better correspond to the possibly changing network conditions.

The functionality of the invention can be implemented by means of a computer or corresponding digital signal processing equipment, such as a general-purpose digital signal processor (DSP), with suitable software therein, for example. It is also possible to use a specific integrated circuit or circuits, or corresponding components and devices. The invention can be implemented in existing system elements, such as various protective relays, or by using separate elements or devices. If the functionality of the invention is implemented by software, such software can be provided as a computer program product comprising computer program code which, when run on a computer, causes the computer or corresponding signal processor to perform the functionality according to the invention as described above. Such a computer program code can be stored on a computer readable medium, such as suitable memory means, e.g. a flash memory or a disc memory from which it is loadable to the unit or units executing the program code. In addition, such a computer program code implementing the invention can be loaded to the unit or units executing the computer program code via a suitable data network, for example, and it can replace or update a possibly existing program code. In the exemplary system of Figure 1, the functionality of the invention could be located in relay units (not shown in the figure) at the beginning of the feeders F1, F2 and F3. It is also possible that only some measurements are performed at the beginning of the feeders and the results are then transmitted to another unit or units (not shown in the figure) in another location for further processing.

It will be obvious to a person skilled in the art that, as the technology advances, the inventive concept can be implemented in various ways. The invention and its embodiments are not limited to the examples described above but may vary within the scope of the claims.

**Claims**

1. A method for determining estimate values for phase-to-earth admittances of a three-phase electric line of an electric power system, the method comprising the steps of:

monitoring voltage and current values of the system, and

determining a sum of phase-to-earth admittances of the electric line (F1, F2, F3) after a phase-to-earth fault has occurred in the electric power system outside the electric line on the basis of a change in a monitored zero-sequence current of the electric line due to the phase-to-earth fault and a change in a monitored zero-sequence voltage of the electric power system due to the phase-to-earth fault, **characterized in that** the method comprises the steps of:

determining an unsymmetrical part and a symmetrical part of the sum of phase-to-earth admittances of the electric line (F1, F2, F3) on the basis of a healthy state zero-sequence voltage of the electric power system, a healthy state zero-sequence current of the electric line, a nominal phase voltage of the electric power system and the sum of phase-to-earth admittances of the electric line, and

determining phase-to-earth admittances of the three-phase electric line (F1, F2, F3) on the basis of the symmetrical part and unsymmetrical part of the sum of phase admittances of the electric line.

2. A method as claimed in claim 1, **characterized in that** the sum of phase-to-earth admittances of the electric line (F1, F2, F3) is determined according to the following formula:

$$\underline{Y}_{0fd} = \frac{3 \cdot \Delta \underline{I}_{0F}}{\Delta \underline{U}_{0F}},$$

where

$\Delta I_{0F}$ = change in the monitored zero-sequence current of the electric line due to a phase-to-earth fault in the electric power system outside the electric line

$\Delta \underline{U}_{0F}$ = change in the monitored zero-sequence voltage of the electric power system due to a phase-to-earth fault in the electric power system outside the electric line.

3. A method as claimed in claim 1 or 2, **characterized in that** the unsymmetrical part of the sum of phase-to-earth admittances of the electric line (F1,F2,F3) is determined according to the following formula:

$$\underline{Y}_{ufd} = \frac{3 \cdot \underline{I}_{0H} - \underline{Y}_{0fd}\underline{U}_{0H}}{j\mathrm{Im}(\underline{Y}_{0fd})U_N} \cdot \underline{Y}_{0fd},$$

where

$\underline{U}_{0H}$ = healthy state zero-sequence voltage of the electric power system

$\underline{I}_{0H}$ = healthy state zero-sequence current of the electric line

$U_N$ = nominal phase voltage of the electric power system

$\underline{Y}_{0fd}$ = sum of phase-to-earth admittances of the electric line,

and **in that** the symmetrical part of the sum of phase-to-earth admittances of the electric line is determined according to the following formula:

$$\underline{Y}_{afd} = \underline{Y}_{0fd} - \underline{Y}_{ufd}.$$

4. A method as claimed in claim 1, 2 or 3, **characterized in that** the phase-to-earth admittances of the electric line (F1, F2, F3) are determined according to the following formulas:

$$\text{Im}(\underline{Y}_{0L1}) = \text{Im}(\frac{\underline{Y}_{afd}}{3} + \underline{Y}_{ufd}') \text{ for phase 1,}$$

$$\text{Im}(\underline{Y}_{0L2}) = \text{Im}(\frac{\underline{Y}_{afd}}{3} + \frac{j\sqrt{3}\underline{Y}_{ufd}}{3}) \text{ for phase 2,}$$

$$\text{Im}(\underline{Y}_{0L3}) = \text{Im}(\frac{\underline{Y}_{afd}}{3} - \frac{j\sqrt{3}\underline{Y}_{ufd}}{3}) \text{ for phase 3,}$$

and

$$\text{Re}(\underline{Y}_{0L1}) = \frac{\sqrt{3}}{3}(\text{Im}(\underline{Y}_{0L3}) - \text{Im}(\underline{Y}_{0L2})) + \text{Re}(\underline{Y}_{afd} + \underline{Y}_{ufd}) - \frac{2}{3}\text{Re}(\underline{Y}_{afd}),$$

$$\text{Re}(\underline{Y}_{0L2}) = \frac{\sqrt{3}}{3}(\text{Im}(\underline{Y}_{0L1}) - \text{Im}(\underline{Y}_{0L3})) + \text{Re}(\underline{Y}_{afd} + \underline{Y}_{ufd}) - \frac{2}{3}\text{Re}(\underline{Y}_{afd} + (1 - \underline{a})\underline{Y}_{ufd}),$$

$$\text{Re}(\underline{Y}_{0L3}) = \frac{\sqrt{3}}{3}(\text{Im}(\underline{Y}_{0L2}) - \text{Im}(\underline{Y}_{0L1})) + \text{Re}(\underline{Y}_{afd} + \underline{Y}_{ufd}) - \frac{2}{3}\text{Re}(\underline{Y}_{afd} + (1 - \underline{a}^2)\underline{Y}_{ufd}),$$

where

$\underline{Y}_{afd}$ = symmetrical part of the sum of phase-to-earth admittances of the electric line
$\underline{Y}_{ufd}$ = unsymmetrical part of the sum of phase-to-earth admittances of the electric line.

5. A method as claimed in any one of claims 1 to 4, **characterized in that** the method further comprises causing a phase-to-earth fault in the electric power system outside the electric line (F1, F2, F3) in order to determine the sum of phase-to-earth admittances of the electric line.

6. A system for determining estimate values for phase-to-earth admittances of a three-phase electric line of an electric power system, the system having means for

monitoring voltage and current values of the system, and for
determining a sum of phase-to-earth admittances of the electric line (F1, F2, F3) after a phase-to-earth fault has occurred in the electric power system outside the electric line on the basis of a change in a monitored zero-sequence current of the electric line due to the phase-to-earth fault and a change in a monitored zero-sequence voltage of the electric power system due to the phase-to-earth fault, **characterized in that** the system further has means for
determining an unsymmetrical part and a symmetrical part of the sum of phase-to-earth admittances of the electric line (F1, F2, F3) on the basis of a healthy state zero-sequence voltage of the electric power system, a healthy state zero-sequence current of the electric line, a nominal phase voltage of the electric power system and the sum of phase-to-earth admittances of the electric line, and for
determining phase-to-earth admittances of the three-phase electric line (F1, F2, F3) on the basis of the symmetrical part and unsymmetrical part of the sum of phase admittances of the electric line.

7. A system as claimed in claim 6, **characterized in that** the system has means for determining the sum of phase-to-earth admittances of the electric line (F1, F2, F3) according to the following formula:

$$\underline{Y}_{0fd} = \frac{3 \cdot \Delta \underline{I}_{0F}}{\Delta \underline{U}_{0F}},$$

where

$\Delta \underline{I}_{0F}$ = change in the monitored zero-sequence current of the electric line due to a phase-to-earth fault in the electric power system outside the electric line
$\Delta \underline{U}_{0F}$ = change in the monitored zero-sequence voltage of the electric power system due to a phase-to-earth fault in the electric power system outside the electric line.

8. A system as claimed in claim 6 or 7, **characterized in that** the system has means for determining the unsymmetrical part of the sum of phase-to-earth admittances of the electric line (F1, F2, F3) according to the following formula:

$$\underline{Y}_{ufd} = \frac{3 \cdot \underline{I}_{0H} - \underline{Y}_{0fd} \underline{U}_{0H}}{j \text{Im}(\underline{Y}_{0fd}) U_N} \cdot \underline{Y}_{0fd},$$

where

$\underline{U}_{0H}$ = healthy state zero-sequence voltage of the electric power system
$\underline{I}_{0H}$ = healthy state zero-sequence current of the electric line
$U_N$ = nominal phase voltage of the electric power system
$\underline{Y}_{0fd}$ = sum of phase-to-earth admittances of the electric line,

and **in that** the system is arranged to determine the symmetrical part of the sum of phase-to-earth admittances of the electric line according to the following formula:

$$\underline{Y}_{afd} = \underline{Y}_{0fd} - \underline{Y}_{ufd}.$$

9. A system as claimed in claim 6, 7 or 8, **characterized in that** the system has means for determining the phase-to-earth admittances of the electric line (F1, F2, F3) according to the following formulas:

$$\text{Im}(\underline{Y}_{0L1}) = \text{Im}(\frac{\underline{Y}_{afd}}{3} + \underline{Y}_{ufd}) \text{ for phase 1 (L1)},$$

$$\text{Im}(\underline{Y}_{0L2}) = \text{Im}(\frac{\underline{Y}_{afd}}{3} + \frac{j\sqrt{3}\underline{Y}_{ufd}}{3}) \text{ for phase 2 (L2)},$$

$$\text{Im}(\underline{Y}_{0L3}) = \text{Im}(\frac{\underline{Y}_{afd}}{3} - \frac{j\sqrt{3}\underline{Y}_{ufd}}{3}) \text{ for phase 3 (L3)},$$

and

$$\mathrm{Re}(\underline{Y}_{0L1}) = \frac{\sqrt{3}}{3}(\mathrm{Im}(\underline{Y}_{0L3}) - \mathrm{Im}(\underline{Y}_{0L2})) + \mathrm{Re}(\underline{Y}_{afd} + \underline{Y}_{ufd}) - \frac{2}{3}\mathrm{Re}(\underline{Y}_{afd}),$$

$$\mathrm{Re}(\underline{Y}_{0L2}) = \frac{\sqrt{3}}{3}(\mathrm{Im}(\underline{Y}_{0L1}) - \mathrm{Im}(\underline{Y}_{0L3})) + \mathrm{Re}(\underline{Y}_{afd} + \underline{Y}_{ufd}) - \frac{2}{3}\mathrm{Re}(\underline{Y}_{afd} + (1 - \underline{a})\underline{Y}_{ufd}),$$

$$\mathrm{Re}(\underline{Y}_{0L3}) = \frac{\sqrt{3}}{3}(\mathrm{Im}(\underline{Y}_{0L2}) - \mathrm{Im}(\underline{Y}_{0L1})) + \mathrm{Re}(\underline{Y}_{afd} + \underline{Y}_{ufd}) - \frac{2}{3}\mathrm{Re}(\underline{Y}_{afd} + (1 - \underline{a}^2)\underline{Y}_{ufd}),$$

where

$\underline{Y}_{afd}$ = symmetrical part of the sum of phase-to-earth admittances of the electric line
$\underline{Y}_{ufd}$ = unsymmetrical part of the sum of phase-to-earth admittances of the electric line.

10. A system as claimed in any one of claims 6 to 9, **characterized in that** the system has means for causing a phase-to-earth fault in the electric power system outside the electric line (F1, F2, F3) in order to determine the sum of phase-to-earth admittances of the electric line.

11. A system according to any one of claims 6 to 10, **characterized in that** the system comprises a protective relay.

12. A computer program product comprising computer program code, wherein the execution of the program code in a computer causes the computer to carry out the steps of the method according to any one of claims 1 to 5.

**Patentansprüche**

1. Verfahren zum Bestimmen von Schätzwerten für Phase-Erde-Admittanzen einer dreiphasigen elektrischen Leitung eines elektrischen Leistungssystems, wobei das Verfahren die Schritte umfasst:

Überwachen von Spannungs- und Stromwerten des Systems und
Bestimmen einer Summe von Phase-Erde-Admittanzen der elektrischen Leitung (F1, F2, F3), nachdem sich ein Erdschluss einer Phase in dem elektrischen Leistungssystem außerhalb der elektrischen Leitung ereignet hat, auf der Grundlage einer Änderung in einem überwachten Nullsequenzstrom der elektrischen Leitung aufgrund des Erdschlusses der Phase und einer Änderung in einer überwachten Nullsequenzspannung des elektrischen Leistungssystems aufgrund des Erdschlusses der Phase,

**dadurch gekennzeichnet, dass** das Verfahren die Schritte umfasst:

Bestimmen eines unsymmetrischen Teils und eines symmetrischen Teils der Summe der Phase-Erde-Admittanzen der elektrischen Leitung (F1, F2, F3) auf der Grundlage einer Nullsequenzspannung des elektrischen Leistungssystems im intakten Zustand, eines Nullsequenzstroms der elektrischen Leitung im intakten Zustand, einer nominalen Phasenspannung des elektrischen Leistungssystems und der Summe der Phase-Erde-Admittanzen der elektrischen Leitung, und
Bestimmen von Phase-Erde-Admittanzen der dreiphasigen elektrischen Leitung (F1, F2, F3) auf der Grundlage des symmetrischen Teils und unsymmetrischen Teils der Summe der Phasenadmittanzen der elektrischen Leitung.

2. Verfahren nach Anspruch 1,
**dadurch gekennzeichnet, dass** die Summe der Phase-Erde-Admittanzen der elektrischen Leitung (F1, F2, F3) gemäß der folgenden Formel bestimmt wird:

$$\underline{Y}_{0fd} = \frac{3 \cdot \Delta \underline{I}_{0F}}{\Delta \underline{U}_{0F}},$$

wobei

$\Delta \underline{I}_{0F}$ die Änderung in dem überwachten Nullsequenzstrom der elektrischen Leitung aufgrund eines Erdschlusses der Phase in dem elektrischen Leitungssystem außerhalb der elektrischen Leitung ist und
$\Delta \underline{U}_{0F}$ die Änderung der überwachten Nullsequenzspannung des elektrischen Leistungssystems aufgrund eines Erdschlusses der Phase in dem elektrischen Leistungssystem außerhalb der elektrischen Leitung ist.

3. Verfahren nach Anspruch 1 oder 2,
   **dadurch gekennzeichnet, dass** der unsymmetrische Teil der Summe der Phase-Erde-Admittanzen der elektrischen Leitung (F1, F2, F3) gemäß der folgenden Formel bestimmt wird:

$$\underline{Y}_{ufd} = \frac{3 \cdot \underline{I}_{0H} - \underline{Y}_{0fd}\underline{U}_{0H}}{j\mathrm{Im}(\underline{Y}_{0fd})U_N} \cdot \underline{Y}_{0fd},$$

wobei

$\underline{U}_{0H}$ die Nullsequenzspannung des elektrischen Leistungssystems im intakten Zustand ist,
$\underline{I}_{0H}$ der Nullsequenzstrom der elektrischen Leitung im intakten Zustand ist,
$U_N$ die nominale Phasenspannung des elektrischen Leistungssystems ist und
$\underline{Y}_{0fd}$ die Summe der Phase-Erde-Admittanzen der elektrischen Leitung ist, und

dadurch, dass der symmetrische Teil der Summe der Phase-Erde-Admittanzen der elektrischen Leitung gemäß der folgenden Formel bestimmt wird:

$$\underline{Y}_{afd} = \underline{Y}_{0fd} - \underline{Y}_{ufd}.$$

4. Verfahren nach Anspruch 1, 2 oder 3,
   **dadurch gekennzeichnet, dass** die Phase-Erde-Admittanzen der elektrischen Leitung (F1, F2, F3) gemäß den folgenden Formeln bestimmt werden:

$$\mathrm{Im}(\underline{Y}_{0L1}) = \mathrm{Im}(\frac{\underline{Y}_{afd}}{3} + \underline{Y}_{ufd}) \quad \text{für Phase 1,}$$

$$\mathrm{Im}(\underline{Y}_{0L2}) = \mathrm{Im}(\frac{\underline{Y}_{afd}}{3} + \frac{j\sqrt{3}\underline{Y}_{ufd}}{3}) \quad \text{für Phase 2,}$$

$$\mathrm{Im}(\underline{Y}_{0L3}) = \mathrm{Im}(\frac{\underline{Y}_{afd}}{3} - \frac{j\sqrt{3}\underline{Y}_{ufd}}{3}) \quad \text{für Phase 3,}$$

und

$$\mathrm{Re}(\underline{Y}_{0L1}) = \frac{\sqrt{3}}{3}(\mathrm{Im}(\underline{Y}_{0L3}) - \mathrm{Im}(\underline{Y}_{0L2})) + \mathrm{Re}(\underline{Y}_{afd} + \underline{Y}_{ufd}) - \frac{2}{3}\mathrm{Re}(\underline{Y}_{afd}),$$

$$\mathrm{Re}(\underline{Y}_{0L2}) = \frac{\sqrt{3}}{3}(\mathrm{Im}(\underline{Y}_{0L1}) - \mathrm{Im}(\underline{Y}_{0L3})) + \mathrm{Re}(\underline{Y}_{afd} + \underline{Y}_{ufd}) - \frac{2}{3}\mathrm{Re}(\underline{Y}_{afd} + (1-\underline{a})\underline{Y}_{ufd}),$$

$$\mathrm{Re}(\underline{Y}_{0L3}) = \frac{\sqrt{3}}{3}(\mathrm{Im}(\underline{Y}_{0L2}) - \mathrm{Im}(\underline{Y}_{0L1})) + \mathrm{Re}(\underline{Y}_{afd} + \underline{Y}_{ufd}) - \frac{2}{3}\mathrm{Re}(\underline{Y}_{afd} + (1-\underline{a}^2)\underline{Y}_{ufd}),$$

wobei

$\underline{Y}_{afd}$ der symmetrische Teil der Summe der Phase-Erde-Admittanzen der elektrischen Leitung ist und
$\underline{Y}_{ufd}$ der unsymmetrische Teil der Summe der Phase-Erde-Admittanzen der elektrischen Leitung ist.

5. Verfahren nach einem der Ansprüche 1 bis 4,
**dadurch gekennzeichnet, dass** das Verfahren ein Bewirken eines Erdschlusses der Phase in dem elektrischen Leistungssystem außerhalb der elektrischen Leitung (F1, F2, F3) umfasst, um die Summe der Phase-Erde-Admittanzen der elektrischen Leitung zu bestimmen.

6. System zum Bestimmen von Schätzwerten für Phase-Erde-Admittanzen einer dreiphasigen elektrischen Leitung eines elektrischen Leistungssystems, wobei das System Mittel aufweist zum

Überwachen von Spannungs- und Stromwerten des Systems und zum
Bestimmen einer Summe von Phase-Erde-Admittanzen der elektrischen Leitung (F1, F2, F3), nachdem sich ein Erdschluss einer Phase in dem elektrischen Leitungssystem außerhalb der elektrischen Leitung ereignet hat, auf der Grundlage einer Änderung in einem überwachten Nullsequenzstrom der elektrischen Leitung aufgrund des Erdschlusses der Phase und einer Änderung in einer überwachten Nullsequenzspannung des elektrischen Leistungssystems aufgrund des Erdschlusses der Phase,

**dadurch gekennzeichnet, dass** das System ferner Mittel aufweist zum

Bestimmen eines unsymmetrischen Teils und eines symmetrischen Teils der Summe der Phase-Erde-Admittanzen der elektrischen Leitung (F1, F2, F3) auf der Grundlage einer Nullsequenzspannung des elektrischen Leistungssystems im intakten Zustand, eines Nullsequenzstroms der elektrischen Leitung im intakten Zustand, einer nominalen Phasenspannung des elektrischen Leistungssystems und der Summe der Phase-Erde-Admittanzen der elektrischen Leitung, und zum
Bestimmen von Phase-Erde-Admittanzen der dreiphasigen elektrischen Leitung (F1, F2, F3) auf der Grundlage des symmetrischen Teils und unsymmetrischen Teils der Summe der Phasenadmittanzen der elektrischen Leitung.

7. System nach Anspruch 6,
**dadurch gekennzeichnet, dass** das System Mittel aufweist zum Bestimmen der Summe der Phase-Erde-Admittanzen der elektrischen Leitung (F1, F2, F3) gemäß der folgenden Formel:

$$\underline{Y}_{0fd} = \frac{3 \cdot \Delta\underline{I}_{0F}}{\Delta\underline{U}_{0F}},$$

wobei

$\Delta \underline{I}_{0F}$ die Änderung in dem überwachten Nullsequenzstrom der elektrischen Leitung aufgrund eines Erdschlusses der Phase in dem elektrischen Leitungssystem außerhalb der elektrischen Leitung ist und

$\Delta \underline{U}_{0F}$ die Änderung der überwachten Nullsequenzspannung des elektrischen Leistungssystems aufgrund eines Erdschlusses der Phase in dem elektrischen Leistungssystem außerhalb der elektrischen Leitung ist.

**8.** System nach Anspruch 6 oder 7,
**dadurch gekennzeichnet, dass** das System Mittel aufweist zum Bestimmen des unsymmetrischen Teils der Summe der Phase-Erde-Admittanzen der elektrischen Leitung (F1, F2, F3) gemäß der folgenden Formel:

$$\underline{Y}_{ufd} = \frac{3 \cdot \underline{I}_{0H} - \underline{Y}_{0fd} \underline{U}_{0H}}{j \mathrm{Im}(\underline{Y}_{0fd}) U_N} \cdot \underline{Y}_{0fd},$$

wobei

$\underline{U}_{0H}$ die Nullsequenzspannung des elektrischen Leistungssystems im intakten Zustand ist,
$\underline{I}_{0H}$ der Nullsequenzstrom der elektrischen Leitung im intakten Zustand ist,
$U_N$ die nominale Phasenspannung des elektrischen Leistungssystems ist und
$\underline{Y}_{0fd}$ die Summe der Phase-Erde-Admittanzen der elektrischen Leitung ist, und

dadurch, dass das System dazu eingerichtet ist, den symmetrischen Teil der Summe der Phase-Erde-Admittanzen der elektrischen Leitung gemäß der folgenden Formel zu bestimmen:

$$\underline{Y}_{afd} = \underline{Y}_{0fd} - \underline{Y}_{ufd}.$$

**9.** System nach Anspruch 6, 7 oder 8,
**dadurch gekennzeichnet, dass** das System Mittel aufweist zum Bestimmen der Phase-Erde-Admittanzen der elektrischen Leitung (F1, F2, F3) gemäß den folgenden Formeln:

$$\mathrm{Im}(\underline{Y}_{0L1}) = \mathrm{Im}(\frac{\underline{Y}_{afd}}{3} + \underline{Y}_{ufd}) \quad \text{für Phase 1 (L1)},$$

$$\mathrm{Im}(\underline{Y}_{0L2}) = \mathrm{Im}(\frac{\underline{Y}_{afd}}{3} + \frac{j\sqrt{3}\underline{Y}_{ufd}}{3}) \quad \text{für Phase 2 (L2)},$$

$$\mathrm{Im}(\underline{Y}_{0L3}) = \mathrm{Im}(\frac{\underline{Y}_{afd}}{3} - \frac{j\sqrt{3}\underline{Y}_{ufd}}{3}) \quad \text{für Phase 3 (L3)},$$

und

$$\mathrm{Re}(\underline{Y}_{0L1}) = \frac{\sqrt{3}}{3}(\mathrm{Im}(\underline{Y}_{0L3}) - \mathrm{Im}(\underline{Y}_{0L2})) + \mathrm{Re}(\underline{Y}_{afd} + \underline{Y}_{ufd}) - \frac{2}{3}\mathrm{Re}(\underline{Y}_{afd}),$$

$$\mathrm{Re}(\underline{Y}_{0L2}) = \frac{\sqrt{3}}{3}(\mathrm{Im}(\underline{Y}_{0L1}) - \mathrm{Im}(\underline{Y}_{0L3})) + \mathrm{Re}(\underline{Y}_{afd} + \underline{Y}_{ufd}) - \frac{2}{3}\mathrm{Re}(\underline{Y}_{afd} + (1 - \underline{a})\underline{Y}_{ufd}),$$

$$\mathrm{Re}(\underline{Y}_{0L3}) = \frac{\sqrt{3}}{3}(\mathrm{Im}(\underline{Y}_{0L2}) - \mathrm{Im}(\underline{Y}_{0L1})) + \mathrm{Re}(\underline{Y}_{afd} + \underline{Y}_{ufd}) - \frac{2}{3}\mathrm{Re}(\underline{Y}_{afd} + (1 - \underline{a}^2)\underline{Y}_{ufd}),$$

wobei

$\underline{Y}_{afd}$ der symmetrische Teil der Summe der Phase-Erde-Admittanzen der elektrischen Leitung ist und
$\underline{Y}_{ufd}$ der unsymmetrische Teil der Summe der Phase-Erde-Admittanzen der elektrischen Leitung ist.

10. System nach einem der Ansprüche 6 bis 9,
   **dadurch gekennzeichnet, dass** das System Mittel aufweist zum Bewirken eines Erdschlusses der Phase in dem elektrischen Leistungssystem außerhalb der elektrischen Leitung (F1, F2, F3), um die Summe der Phase-Erde-Admittanzen in der elektrischen Leitung zu bestimmen.

11. System nach einem der Ansprüche 6 bis 10,
   **dadurch gekennzeichnet, dass** das System ein Schutzrelais aufweist.

12. Computerprogrammprodukt, welches Computerprogrammcode umfasst, wobei die Ausführung des Programmcodes in einem Computer bewirkt, dass der Computer die Schritte des Verfahrens nach einem der Ansprüche 1 bis 5 ausführt.

## Revendications

1. Procédé de détermination de valeurs estimées pour des admittances entre phase et terre d'une ligne électrique triphasée d'un système d'alimentation électrique, le procédé comprenant les étapes de :

   surveillance des valeurs de tension et de courant du système et
   détermination d'une somme d'admittances entre phase et terre de la ligne électrique (F1, F2, F3) après qu'un défaut entre phase et terre est survenu dans le système d'alimentation électrique à l'extérieur de la ligne électrique sur la base d'une variation d'un courant homopolaire surveillé de la ligne électrique dû au défaut entre phase et terre et sur la base d'une variation d'une tension homopolaire surveillée du système d'alimentation électrique dû au défaut entre phase et terre,
   **caractérisé en ce que** le procédé comprend les étapes de :

   détermination d'une partie asymétrique et d'une partie symétrique de la somme des admittances entre phase et terre de la ligne électrique (F1, F2, F3) sur la base d'une tension homopolaire saine du système d'alimentation électrique, d'un courant homopolaire sain de la ligne électrique, d'une tension de phase nominale du système d'alimentation électrique et de la somme des admittances entre phase et terre de la ligne électrique, et
   détermination des admittances entre phase et terre de la ligne électrique triphasée (F1, F2, F3) sur la base de la partie symétrique et de la partie asymétrique de la somme des admittances de phase de la ligne électrique.

2. Procédé selon la revendication 1, **caractérisé en ce que** la somme des admittances entre phase et terre de la ligne électrique (F1, F2, F3) est déterminée selon la formule suivante :

$$\underline{Y}_{0fd} = \frac{3 \cdot \Delta \underline{I}_{0F}}{\Delta \underline{U}_{0F}},$$

où

$\Delta \underline{I}_{0F}$ = variation du courant homopolaire surveillé de la ligne électrique dû à un défaut entre phase et terre dans le système d'alimentation électrique à l'extérieur de la ligne électrique

$\Delta \underline{U}_{0F}$ = variation de la tension homopolaire surveillée du système d'alimentation électrique dû à un défaut entre phase et terre dans le système d'alimentation électrique à l'extérieur de la ligne électrique.

3. Procédé selon la revendication 1 ou 2, **caractérisé en ce que** la partie asymétrique de la somme des admittances entre phase et terre de la ligne électrique (F1, F2, F3) est déterminée selon la formule suivante :

$$\underline{Y}_{ufd} = \frac{3 \cdot \underline{I}_{0H} - \underline{Y}_{0fd}\underline{U}_{0H}}{j\mathrm{Im}(\underline{Y}_{0fd})U_N} \cdot \underline{Y}_{0fd},$$

où

$\underline{U}_{0H}$ = tension homopolaire saine du système d'alimentation électrique

$\underline{I}_{0H}$ = courant homopolaire sain de la ligne électrique

$U_N$ = tension de phase nominale du système d'alimentation électrique

$\underline{Y}_{0fd}$ = somme des admittances entre phase et terre de la ligne électrique,

et **en ce que** la partie symétrique de la somme des admittances entre phase et terre de la ligne électrique est déterminée selon la formule suivante :

$$\underline{Y}_{afd} = \underline{Y}_{0fd} - \underline{Y}_{ufd}.$$

4. Procédé selon la revendication 1, 2 ou 3, **caractérisé en ce que** les admittances entre phase et terre de la ligne électrique (F1, F2, F3) sont déterminées selon les formules suivantes :

$$\mathrm{Im}(\underline{Y}_{0L1}) = \mathrm{Im}\left(\frac{\underline{Y}_{afd}}{3} + \underline{Y}_{ufd}\right) \quad \text{pour la phase 1,}$$

$$\mathrm{Im}(\underline{Y}_{0L2}) = \mathrm{Im}\left(\frac{\underline{Y}_{afd}}{3} + \frac{j\sqrt{3}\underline{Y}_{ufd}}{3}\right) \quad \text{pour la phase 2,}$$

$$\mathrm{Im}(\underline{Y}_{0L3}) = \mathrm{Im}\left(\frac{\underline{Y}_{afd}}{3} - \frac{j\sqrt{3}\underline{Y}_{ufd}}{3}\right) \quad \text{pour la phase 3,}$$

et

$$\text{Re}(\underline{Y}_{0L1}) = \frac{\sqrt{3}}{3}(\text{Im}(\underline{Y}_{0L3}) - \text{Im}(\underline{Y}_{0L2})) + \text{Re}(\underline{Y}_{afd} + \underline{Y}_{ufd}) - \frac{2}{3}\text{Re}(\underline{Y}_{afd})$$

,

$$\text{Re}(\underline{Y}_{0L2}) = \frac{\sqrt{3}}{3}(\text{Im}(\underline{Y}_{0L1}) - \text{Im}(\underline{Y}_{0L3})) + \text{Re}(\underline{Y}_{afd} + \underline{Y}_{ufd}) - \frac{2}{3}\text{Re}(\underline{Y}_{afd} + (1 - \underline{a})\underline{Y}_{ufd})$$

,

$$\text{Re}(\underline{Y}_{0L3}) = \frac{\sqrt{3}}{3}(\text{Im}(\underline{Y}_{0L2}) - \text{Im}(\underline{Y}_{0L1})) + \text{Re}(\underline{Y}_{afd} + \underline{Y}_{ufd}) - \frac{2}{3}\text{Re}(\underline{Y}_{afd} + (1 - \underline{a}^2)\underline{Y}_{ufd})$$

,

où

$\underline{Y}_{afd}$ = partie symétrique de la somme des admittances entre phase et terre de la ligne électrique
$\underline{Y}_{ufd}$ = partie asymétrique de la somme des admittances entre phase et terre de la ligne électrique.

5. Procédé selon l'une quelconque des revendications 1 à 4, **caractérisé en ce que** le procédé comprend la génération d'un défaut entre phase et terre dans le système d'alimentation électrique à l'extérieur de la ligne électrique (F1, F2, F3) afin de déterminer la somme des admittances entre phase et terre de la ligne électrique.

6. Système de détermination de valeurs estimées pour des admittances entre phase et terre d'une ligne électrique triphasée d'un système d'alimentation électrique, le système ayant des moyens de

surveillance de valeurs de tension et de courant du système, et
détermination d'une somme d'admittances entre phase et terre de la ligne électrique (F1, F2, F3) après qu'un défaut entre phase et terre est survenu dans le système d'alimentation électrique à l'extérieur de la ligne électrique sur la base d'une variation d'un courant homopolaire surveillé de la ligne électrique dû au défaut entre phase et terre et sur la base d'une variation d'une tension homopolaire surveillée du système d'alimentation électrique dû au défaut entre phase et terre, **caractérisé en ce que** le système a en outre des moyens de détermination d'une partie asymétrique et d'une partie symétrique de la somme des admittances entre phase et terre de la ligne électrique (F1, F2, F3) sur la base d'une tension homopolaire saine du système d'alimentation électrique, d'un courant homopolaire sain de la ligne électrique, d'une tension de phase nominale du système d'alimentation électrique et de la somme des admittances entre phase et terre de la ligne électrique, et détermination des admittances entre phase et terre de la ligne électrique triphasée (F1, F2, F3) sur la base de la partie symétrique et de la partie asymétrique de la somme des admittances de phase de la ligne électrique.

7. Système selon la revendication 6, **caractérisé en ce que** le système a un moyen de détermination de la somme des admittances entre phase et terre de la ligne électrique (F1, F2, F3) selon la formule suivante :

$$\underline{Y}_{0fd} = \frac{3 \cdot \Delta \underline{I}_{0F}}{\Delta \underline{U}_{0F}}$$

,

où

$\Delta \underline{I}_{0f}$ = variation du courant homopolaire surveillé de la ligne électrique dû à un défaut entre phase et terre dans le système d'alimentation électrique à l'extérieur de la ligne électrique
$\Delta \underline{U}_{0f}$ = variation de la tension homopolaire surveillée du système d'alimentation électrique dû à un défaut entre phase et terre dans le système d'alimentation électrique à l'extérieur de la ligne électrique.

8. Système selon la revendication 6 ou 7, **caractérisé en ce que** le système a un moyen de détermination de la partie asymétrique de la somme des admittances entre phase et terre de la ligne électrique (F1, F2, F3) selon la formule suivante :

$$\underline{Y}_{ufd} = \frac{3 \cdot \underline{I}_{0H} - \underline{Y}_{0fd}\underline{U}_{0H}}{j\mathrm{Im}(\underline{Y}_{0fd})U_N} \cdot \underline{Y}_{0fd},$$

où

$\underline{U}_{0H}$ = tension homopolaire saine du système d'alimentation électrique
$\underline{I}_{0H}$ = courant homopolaire sain de la ligne électrique
$U_N$ = tension de phase nominale du système d'alimentation électrique
$\underline{Y}_{0fd}$ = somme des admittances entre phase et terre de la ligne électrique,

et **en ce que** le système est agencé pour déterminer la partie symétrique de la somme des admittances entre phase et terre de la ligne électrique selon la formule suivante :

$$\underline{Y}_{afd} = \underline{Y}_{0fd} - \underline{Y}_{ufd}.$$

9. Système selon la revendication 6, 7 ou 8, **caractérisé en ce que** le système a un moyen de détermination des admittances entre phase et terre de la ligne électrique (F1, F2, F3) selon les formules suivantes :

$$\mathrm{Im}(\underline{Y}_{0L1}) = \mathrm{Im}(\frac{\underline{Y}_{afd}}{3} + \underline{Y}_{ufd}) \quad \text{pour la phase 1 (L1),}$$

$$\mathrm{Im}(\underline{Y}_{0L2}) = \mathrm{Im}(\frac{\underline{Y}_{afd}}{3} + \frac{j\sqrt{3}\underline{Y}_{ufd}}{3}) \quad \text{pour la phase 2 (L2),}$$

$$\mathrm{Im}(\underline{Y}_{0L3}) = \mathrm{Im}(\frac{\underline{Y}_{afd}}{3} - \frac{j\sqrt{3}\underline{Y}_{ufd}}{3}) \quad \text{pour la phase 3 (L3),}$$

et

$$\mathrm{Re}(\underline{Y}_{0L1}) = \frac{\sqrt{3}}{3}(\mathrm{Im}(\underline{Y}_{0L3}) - \mathrm{Im}(\underline{Y}_{0L2})) + \mathrm{Re}(\underline{Y}_{afd} + \underline{Y}_{ufd}) - \frac{2}{3}\mathrm{Re}(\underline{Y}_{afd}),$$

$$\mathrm{Re}(\underline{Y}_{0L2}) = \frac{\sqrt{3}}{3}(\mathrm{Im}(\underline{Y}_{0L1}) - \mathrm{Im}(\underline{Y}_{0L3})) + \mathrm{Re}(\underline{Y}_{afd} + \underline{Y}_{ufd}) - \frac{2}{3}\mathrm{Re}(\underline{Y}_{afd} + (1-\underline{a})\underline{Y}_{ufd})$$

,

$$\mathrm{Re}(\underline{Y}_{0L3}) = \frac{\sqrt{3}}{3}(\mathrm{Im}(\underline{Y}_{0L2}) - \mathrm{Im}(\underline{Y}_{0L1})) + \mathrm{Re}(\underline{Y}_{afd} + \underline{Y}_{ufd}) - \frac{2}{3}\mathrm{Re}(\underline{Y}_{afd} + (1-\underline{a}^2)\underline{Y}_{ufd})$$

où

$\underline{Y}_{afd}$ = partie symétrique de la somme des admittances entre phase et terre de la ligne électrique
$\underline{Y}_{ufd}$ = partie asymétrique de la somme des admittances entre phase et terre de la ligne électrique.

10. Système selon l'une quelconque des revendications 6 à 9, **caractérisé en ce que** le système a un moyen de génération d'un défaut entre phase et terre dans le système d'alimentation électrique à l'extérieur de la ligne électrique (F1, F2, F3) afin de déterminer la somme des admittances entre phase et terre de la ligne électrique.

11. Système selon l'une quelconque des revendications 6 à 10, **caractérisé en ce que** le système comprend un relais de protection.

12. Programme-produit d'ordinateur comprenant un code de programme d'ordinateur, dans lequel l'exécution du code de programme dans un ordinateur entraine que l'ordinateur effectue les étapes du procédé selon une des revendications 1 à 5.

Fig. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0122104 A

### Non-patent literature cited in the description

- **ARI NIKANDER.** Novel Methods for Earth Fault Management in Isolated or Compensated Medium Voltage Electricity Distribution Networks. Tampere University of Technology, Publications 363, 2002
- **JEFF ROBERTS et al.** New directional ground-fault element improve sensitivity in ungrounded and compensated networks. Schweitzer Engineering Laboratories, 2001

- **ARI NIKANDER et al.** Methods for earth fault identification and distance estimation in a compensated medium voltage distribution network. *IEEE Cat. No: 98EX137,* 595-600